# EUROPEAN PATENT SPECIFICATION

(11) **EP 1 984 462 B1**
(45) Date of publication and mention of the grant of the patent: **04.07.2012**
(21) Application number: 07704279.4
(22) Date of filing: 31.01.2007
(51) Int. Cl.: C09D 5/44, C25D 15/00, B81C 1/00

(54) **ELECTROGRAFTING METHOD FOR FORMING AND REGULATING A STRONG ADHERENT NANOSTRUCTURED POLYMER COATING**
ELEKTROPFROPFVERFAHREN ZUR BILDUNG UND REGULIERUNG EINER STARK HAFTENDEN NANOSTRUKTURIERTEN POLYMERBESCHICHTUNG
PROCÉDÉ D'ÉLECTROGREFFAGE POUR FORMER ET RÉGULER UN REVÊTEMENT DE POLYMÈRE NANOSTRUCTURÉ À FORTE ADHÉRENCE

(30) Priority: 10.02.2006 EP 06101558
(43) Date of publication of application: 29.10.2008
(73) Proprietor: Université de Liège, 4031 Angleur (BE)
(72) Inventor: JEROME, Robert, B-4845 Sart-Jalhay (BE); JEROME, Christine, B-4102 Ougrée (BE); SERWAS, Harry, B-4720 La Calamine (BE); VOCCIA, Samuel, B-4000 Liège (BE)
(86) International application number: PCT/EP2007/050956
(87) International publication number: WO 2007/090779

(56) References cited:
- WO-A-02/098926
- US-A1- 2004 081 900
- US-A1- 2005 253 206
- S. PALACIN ET AL: "Molecule-to-Metal Bonds: Electrografting Polymers on Conducting Surfaces" CHEMPHYSCHEM, [Online] vol. 5, no. 10, 14 October 2004 (2004-10-14), pages 1468-1481, XP002382047 Retrieved from the Internet: URL:http://www3.interscience.wiley.com/cgi -bin/fulltext/109712203/PDFSTART> [retrieved on 2006-05-22]
- J. CHARLIER ET AL: "Mask-Free Localised Grafting of Organic Polymers at the Micrometer or Submicrometer Scale on Composite Conductors or Semiconductor Substrates" ADVANCED FUNCTIONAL MATERIALS, [Online] vol. 14, no. 2, 11 February 2004 (2004-02-11), pages 125-132, XP002382048 Retrieved from the Internet: URL:http://www3.interscience.wiley.com/cgi -bin/fulltext/107614817/PDFSTART> [retrieved on 2006-05-22]

## Description

The present invention relates to a new method for forming and regulating by electrografting a strongly adherent nanostructured polymer coating onto an electro-conductive surface by controlling its surface profile. The present invention also relates to the strongly adherent nanostructured polymer coating obtained thereof and its uses.

Electrografting methods for forming a polymer coating are known in the art. WO 02/098926 and WO 2005/033378 describe a polymer film forming at the surface of an electroconductive surface. Nevertheless, the polymer coatings obtained by such methods known in the art require aprotic or nearly aprotic conditions to be formed. Organic solvents are therefore required which are costly and toxici for the environment.

WO 2005/033378 describes that protic substances like Brönsted acids hinder anionic polymerisation during preparation of a polymer coating by electrografting. Cathodic polarisation induces an anionic polymerisation which is stopped in the presence of protic compounds because propagating anions react irreversibly with the said protic compounds. The formation of a strongly adherent polymer coating is thus impossible in the presence of such protic compounds and only very low molecular weight polymer chains may be formed at the cathode.

Moreover, if some regulation of such polymer-coated surfaces is possible in the electrografting methods described in WO 02/098926, it is limited to a rough thickness control of the polymeric coating onto the surface. No other specific properties of the conductive surface profile (such as for example, roughness) are regulated during the electro-coating preparation.

One interesting characteristic of the surface profile is its surface roughness which influences many properties of the surface such as its wetting, adhesion, compatibility and reactivity with one or more polymeric coating. "Surface roughness" in the context of the present invention can be defined as small-scale (i.e., nanometer- and/or micrometer-scale) variations in the height of a solid surface as would be caused by a plurality of nodular formations present on a surface.

The surface roughness has an influence on many properties of the said surface and cannot be easily tuned while preparing a strongly adherent coating. On the other hand, because a modification of the surface roughness can enhance existing properties or impart new properties to a surface, the control of surface roughness is desired for many applications. Varying the surface roughness may for example modify the wetting, adhesion and reactivity properties of the surface. It can also enhance or reduce the contact between two surfaces, the friction at the surface, the specific area of a surface, the refractive index and so on.

Beside the good adhesion of the coatings, all these properties are of the utmost importance if the coating has to be used for example as self-cleaning surfaces, as anti-adhesive surfaces, in anti-corrosion, for the design of biosensors, as a primer to promote adhesion of a second coating or as molecular Velcro to form composites of different materials. For example, biosensors may be more sensitive if the surface area of the functional coating used to detect an analyte is increased. Furthermore, it can be desirable to optimize the wetting properties of these functional coatings used in biosensors and this can also be easily done by tuning the surface profile, particularly the surface roughness.

We have now found a new electrografting method comprising a step of nuclei deposition at a conductive surface regulating its surface profile and the polymeric coating properties before, during or resulting from electrografting. The surface profile is therefore controlled by a controlled nucleation step at the conductive surface inducing nanostructuration of the coating.

Accordingly, the present invention provides an electrografting method for forming and regulating a strongly adherent nanostructured polymer coating onto an electro-conductive surface profile characterized in that the surface profile is regulated by electrodeposition of nanometre- and/or micrometre-scale nuclei onto the surface profile prior to or simultaneously to the formation of the polymer coating, and characterized in that the nuclei are made of an organic material provided by electrodeposition from a monomer droplet or from a monomer droplet which is provided by an emulsion comprising the monomer in a protic solvent.

In the context of the present invention, the term "nuclei" refers to a nodule of an electrodeposited material with a nanometre- and/or micrometer-scale diameter, wherein the diameter is considered to be the greatest diameter of the nodule.

The electrografting method according to the present invention may be carried out with conventional electrochemical techniques, as for example, a three-electrode cell connected to a potentiostat. A working electrode, i.e., the electroconductive surface to be electrocoated, is a conductive or semi-conductive surface made for example from noble metals such as gold or platinum, transition metals such as chromium, titanium, iron, copper or nickel, or semi-conductors, such as doped silicon or carbon.

Moreover, the electrografting method according to the present invention may be successfully applied to a surface of any size and shape. For example, surfaces of medical devices, such as coronary stents, dentistry tools or surfaces of analytical devices, such as atomic force microscopy (AFM) tips, microelectronic circuitry, microfluidic devices and also conducting (metallic) surfaces used in packaging, householding, the automobile sector, or design goods.

The advantages of such embodiments for the nanostructured strongly adhering polymer coatings are a precise tailoring of both chemistry and topography of the (semi)-conducting surface. When controlling both parameters, new properties can be afford to the coated material, such as superhydrophobicity, superhydrophilicity and anti-fouling properties. Other surface properties can also be deeply enhanced such as anti-bacterial activity, reactivity, catalytic reaction selectivity, friction, and reflectivity.

Applications of such nanostructured and strong adhering polymer coatings are found when corrosion-resistant coatings and self-cleaning coatings are required for biocompatibilization or the building-up of bioactive medical implants, for the elaboration of (bio)sensors particularly electrochemical biocaptors, for functionalization of channels of microfluidic devices, for tuning the visual aspect of goods (for example, decorative handles and watches), for imparting anti-bacterial properties to surfaces (such as air filters and medical tools).

In one embodiment, the present invention provides an electrografting method wherein the nuclei are made of an organic material provided by electrodeposition from monomer droplets.

By monomer droplet is meant a droplet comprising a monomer (M). A monomer droplet is for example an emulsion droplet as illustrated in scheme 1A and comprising a monomer (M), a surfactant (Su) and a protic solvent (PSo) or a droplet as illustrated in scheme 1B comprising a reactive amphiphile (R) in a selective (protic) solvent (SSo).

Reactive amphiphile is defined as a molecule comprising a hydrophilic part and a hydrophobic part, and bearing at least one polymerizable moiety such as a (meth)acrylic function as illustrated in scheme 2.

The protic solvent according to the present embodiment means a solvent having one dissociable proton such as water, but also methanol, ethanol, formamide and the like and combinations thereof.

The surfactant according to the present embodiment may be any molecule comprising a hydrophilic part and a hydrophobic part. The surfactant may be an anionic (such as sodium dodecyl sulfate), a cationic (such as alkyl quaternary ammonium), a zwiterionic (such as betaines), or a neutral (non-ionic) (such as pluronics) surfactant.

The amount of surfactant which is added in the emulsion, preferably exceeds the critical micellar concentration (CMC) of the surfactant in the protic solvent. It is, for example, 10⁻⁷ M to 10 M, preferably between 10⁻⁵ M to 10⁻¹ M.

The electrografting method using such monomer containing droplets allows regulating both topography and chemistry of the (semi)-conducting surface by electrochemical formation of organic (polymer) nuclei onto the conductive surface upon application of a potential z to said surface.

By the application of at least one selected potential z to the electricallyconductive or semiconductive surface of electrode (E), the droplets of the monomer which are formed in a protic solvent such as water may form a nanostructured strongly adherent polymer coating (C) on the electrically conductive or semiconductive surface as illustrated in scheme 3.

The monomer droplets upon applying a potential to the electrically conductive surface may be attracted to the electrically conductive surface (scheme 3 step 1). The droplets of the monomer which are formed in the protic solvent may be projected onto the electrically conductive surface, forming nuclei at the surface, and therefore modifying the profile of the conductive surface. While upon reaching said surface, the formation of a strongly adherent polymer coating begins at the edge of the droplets which first contacts with the electrically conductive surface. Each said droplet may therefore form a strongly adherent polymer protuberance, especially a hemispheric or ellipsoidal polymer protuberance, on the electrically conductive surface (scheme 3). Depending on the potential which is used to project the droplets against the electrode, the crash of the droplets may be strong enough to spread the monomer on the electrode so that a smoother coating may be obtained.

The diameter of the polymer protuberances of the strongly adherent polymer coating which are formed on the electrically (semi)conductive surface may depend on the diameter of the droplets which are formed in the protic solvent.

It is therefore possible to tune the conductive surface profile particularly the surface roughness of the at least partially polymer coated surface by modifying the diameter of the droplets of the monomer which may be formed in the protic solvent and/or by tuning the selected potential(s) which may be applied to the electrically conductive or semiconductive surface, going progressively from a nearly smooth polymer coated surface, which can for example be obtained using small droplets, especially, for example, droplets with a mean diameter < 100 nm, and/or high potential(s), to a rough polymer coated surface, which can for example be obtained using large droplets, especially, for example, droplets and/or aggregates with a diameter > 100 nm, and/or low potential(s).

The selected potential y applied to the electrically conductive surface may be, for example, in the potential range between 10 V and -10 V, preferably between 0 V and -4.5 V. In some preferred embodiments of the present invention, the potential applied to the electrically conductive or semiconductive surface may vary during application, for example, at a speed between 0.1 mV/s and 5 V/s, preferred between 1 mV/s and 250 mV/s. Furthermore, a constant potential may be applied to the electrically conductive or semiconductive surface, for example, during between 0.001 seconds and 15 minutes, preferably 0.1 seconds and 1 minute.

The monomer involved in the monomer droplets in the embodiment of the invention is any kind of acrylic or methacrylic derivatives, such as alkyl(meth)acrylate, fluorinated (meth)acrylate, succinimidyl (meth)acrylate, pyrrole (meth)acrylate, thiophene (meth)acrylate, and so on, and polymers bearing one or more acrylic or methacrylic functions, such as polysiloxanes, polyesters, polyurethanes, poly(methylvinyl ether), polystyrene, polyethers, and the monomers and polymers described in WO 02/098926 incorporated herein by reference.

In the embodiment of the invention, the electroconductive surface is also preferably immersed in a micellar composition comprising a reactive amphiphile in a selective (protic)solvent (Sso).

The reactive amphiphile (also called a reactive surfactant) involved in the monomer droplets in case of micelles are amphiphilic monomers that self-assemble in a selective solvent (eg, water). For example, alkyl quaternary ammonium bearing a (meth)acrylate, amphiphilic block copolymers bearing one or several (meth)acrylic functions on one block, or a combination thereof.

Emulsions in water require hydrophobic monomers and consequently lead to polymer coatings with a hydrophobic character (if prepared in one step). Whenever hydrophilic coatings have to be prepared in one step in water, the emulsion has to be replaced by a micellar composition as illustrated in scheme 1B. For that purpose, reactive surfactants have to be prepared that meet several requirements. Such reactive surfactants have to be able to form micelles in water, to repulse water from the electrical double layer upon polarization and to electrochemically react to form the strongly adhering nanostructured coating. Examples of suitable monomers for this strategy are described in scheme 2. Indeed in schemes 2A and 2B, there is illustrated amphiphilic and reactive (acrylic derivative) molecules that are able to self-associate in water to form micelles thanks to their hydrophilic (charged) and hydrophobic (long alkyl chain) character, whereas because of the (meth)acrylic group they can also electropolymerize. In such systems, the polymer coating is built by the polymerized surfactant and thus includes some charged groups that increases the hydrophilicity of the coating.

In scheme 2C, a similar use of a polymeric reactive surfactant is illustrated.

In such cases, the hydrophilic part and the hydrophobic part are constituted by two polymer sequences, one made of a hydrophilic polymer, such as poly(ethylene oxide) or quaternized poly(vinylpyridine), and one made of a hydrophobic chain bearing at least one (meth)acrylic group, for example a copolymer of ε-caprolactone and γ-acryloyl-ε-caprolactone.

Most advantageous of the invention is the use of protic solvents, and particularly the cheap, non-toxic solvent water, a solvent being particularly opportune for the industrial development of the method of the invention.

The present invention also refers to a strong adherent nanostructured polymer coating obtained by the electrografting method according to the invention. The nanostructuration is made of nuclei that can be provided by organic (monomer) droplet that may be further polymerized to form a polymer aggregate and formation of a nanostructured polymer coating.

The invention is now illustrated with reference to the following Schemes and Figures of the accompanying drawings:

### Scheme 1:

Schematic description of the monomer droplets of the embodiment of the invention showing an emulsion system (diagram A) and a micellar system (diagram B), wherein M represents a hydrophobic monomer, Su a surfactant , RSu a reactive surfactant, PSo a protic solvent, and SSo a selective solvent.

### Scheme 2:

Possible structures for the reactive surfactants able to give micelles as monomer droplets. Diagram C shows a polymeric surfactant with one hydrophilic (left-side part) and one hydrophobic and reactive (right-side part) segments.

### Scheme 3:

Schematic description of the nanostructuration of the surface by using the monomer droplets systems. Firstly, the monomer droplets (M) are in suspension in the solvent (e.g. water) (left-side image). Then, upon polarization (middle image), some droplets go to the electrode (E) surface forming there nuclei from which the electropolymerization starts. The polymer grown from these droplets nuclei forms a nanostructured coating (C) (right-side image), the nanostructuration originating from the original monomer compartmentation within the droplets.
**Fig. 1****:** Voltammogram illustrating the embodiment of the invention for the reduction of an emulsion of heptadecafluorodecyl acrylate (2M) with cetyltrimethylammonium bromide as surfactant recorded on carbon surface (A), with two reduction cycles (1 and 2) on the same electrode, and (B) different substrates (i.e., SS: stainless steel, SiHC: higly-doped silicon, SiLC: slightly-doped silicon, C: carbon) as performed in **example 1.**
**Fig. 2****:** AFM micrographs showing the nanostructuration of steel (micrograph A) and carbon (micrograph B) surfaces after electrografting step as described in **example 1** for the embodiment of the invention.
**Fig. 3****:** Voltammogram illustrating the embodiment for the reduction of a micellar solution of reactive monomer on carbon surface as performed in **example 2.**

The invention will now be illustrated with reference to the following examples which are not intended to limit the scope of the claimed invention.

### Example 1: Preparation of nanostructured surfaces from monomer droplets consisting of an emulsion in protic solvents

Emulsions are used to create droplets of an organic hydrophobic compound, the monomer, in protic hydrophilic medium, e.g. water. The emulsion of hydrophobic acrylates in water has been performed in the presence of a cationic surfactant (long alkyl chain bearing quaternary ammonium groups). Moreover the conductivity of the solution is thus ensured by the cationic surfactant, so there is no need to add other salt to the medium.

Acetonitrile (Aldrich), tert-butyl methacrylate (tBMA, Aldrich), isooctyl acrylate (iOA, Aldrich) and heptadecafluorodecyl acrylate (HDFDA, ABCR) were dried over calcium hydride and distilled under reduced pressure. Dimethylformamide (DMF, Aldrich) was dried over P₂O₅ and distilled under reduced pressure. Tetraethylammonium perchlorate (TEAP, Fluka) and copper(II) acetate (Aldrich) were heated in vacuum at 80 °C for 12 h prior to use.

Voltammetry and chronoamperometry were carried out in a one-compartment cell equipped with a platinum counter-electrode and a platinum pseudo-reference by using an EG&G potentiostat/galvanostat (M273) under the ambient atmosphere. The working electrode (2 cm² stainless steel, silicon or carbon plates) was washed with heptane and acetone (the silicon plates were washed with HF), and dried overnight at 150 °C in a vacuum. The working electrode was immersed in dry DMF containing the acrylate (tBMA) (1.5 M) or HDFDA (2 M), the surfactant cetyltrimethylammonium bromide (12.5 mg) and a selected potential was applied. The potential varies at 20 mV/s during voltammetry. The nanostructured surfaces were washed extensively with dry DMF followed by acetonitrile in the case of PtBMA and by trifluorotoluene when fluorinated polyacrylate was used. The nanostructured surface was dried in vacuum before characterization.

### Preparation of nanostructured poly(heptadecafluorodecyl)acrylate coatings in water : formation of superhydrophobic surfaces

If a surfactant, cetyltrimethylammonium bromide, is added to water until saturation, the surfactant self-associates and may be characterized by dynamic light scattering (DLS). The diameter of the observed aggregates is large, about 3 to 10µm, with a mean diameter of about 5 µm these aggregates are formed of micellar rods.

After addition of the acrylate (HDFDA) and a subsequent sonication, an emulsion comprising droplets of HDFDA at least partially surrounded by the surfactant molecules is formed in the protic solvent. The diameter of the droplets of HDFDA of the emulsion may also be measured by DLS. The diameter of the droplets is about 600 nm to 800 nm, with a mean diameter of about 700 nm.

The formation of the strongly adherent polymer coating is performed in an electrochemical cell containing 5 ml of a 2M HDFDA solution comprising 12.5 mg of cetyltrimethylammonium bromide in water at about -2 V on doped-silicon, steel and carbon. The cationic surfactant insures the conductivity of the aqueous solution. After each application of a selected potential the electrically conductive or semiconductive surface is washed with water and trifluorotoluene.

Cetyltrimethylammonium bromide surfactant comprises an alkyl chain containing 16 carbon atoms and is only poorly soluble in the aqueous solution (saturation for about 30mg of surfactant added to 10 ml water 2M in HDFDA).

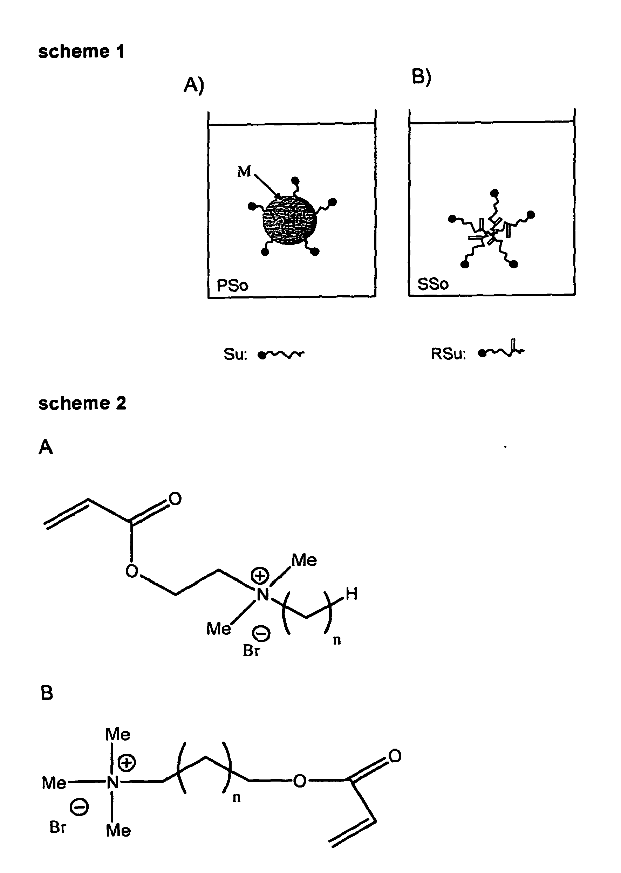

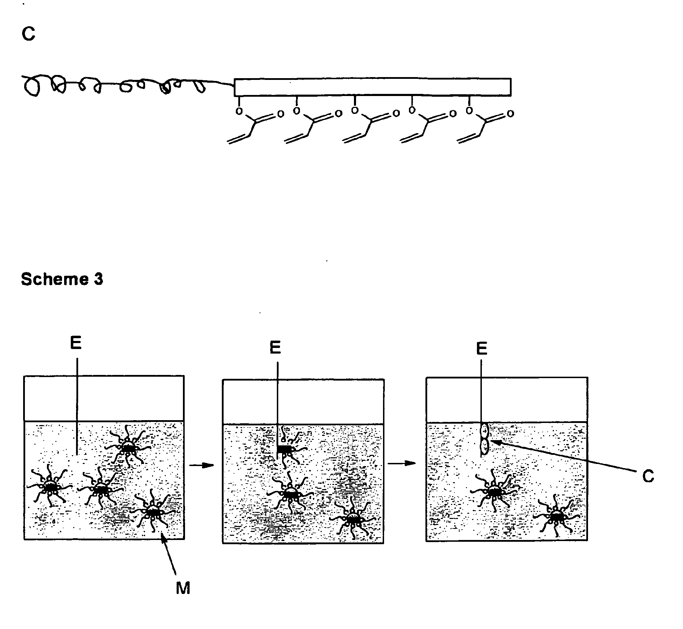

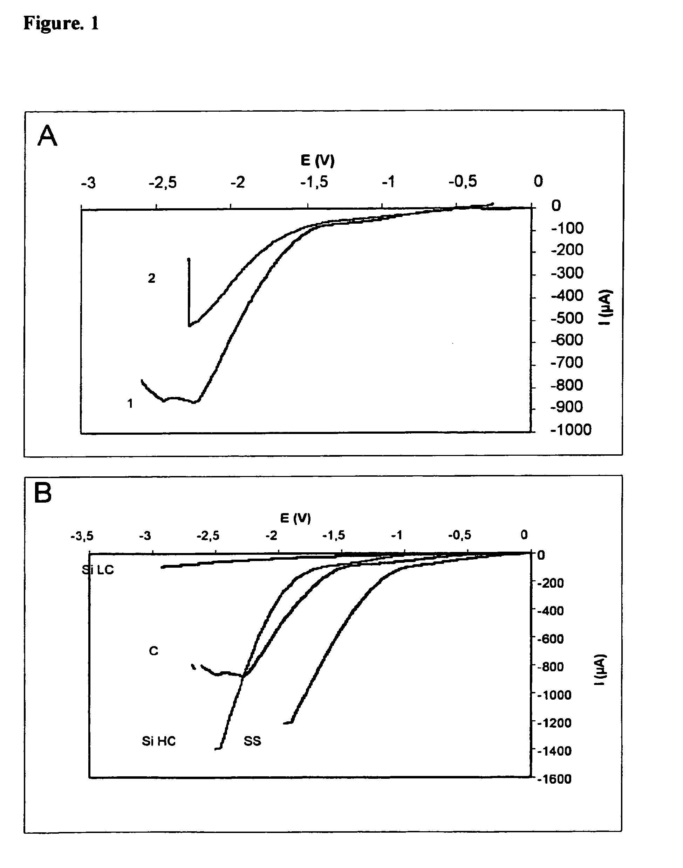

However, a decrease of the current intensity is measured after each scan (Figure 1). The current intensity corresponding to the hydrolysis of H₂O decreases after each potential scanning, because hydrophocicity of the electrically conductive or semiconductive surface increases due to the formation of a strongly adherent hydrophobic polymer coating which reduces the access of water to the working electrode.

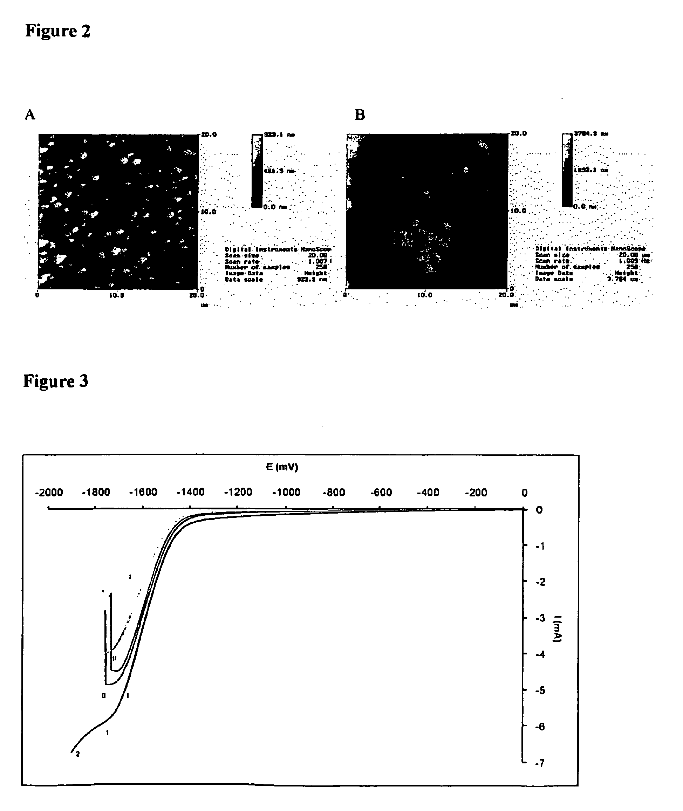

The formation of a strongly adherent fluorinated polyacrylate coating on steel, stainless steel, carbon and silicon (of different resistivity values from 0.001 Ω*cm heavily p- and n-doped Si, to 50 Ω*cm lightly n-doped Si: LC= low conductivity and HC= high conductivity) surfaces evidenced by voltammetry (Figure 4) is confirmed by ATR-FTIR Absorptions characteristic of the polymer are observed at 1727 cm⁻¹ (C=O stretching vibration) and 1157 cm⁻¹ (CO stretching vibration). The contact angle values measured for the different nanostructured surfaces confirm the presence of a strongly adherent hydrophobic poly(HDFDA) on the different electrically conductive or semiconductive surfaces. Depending on the method which is used, chronoamperometry or voltammetry, the contact angle of water may vary. However all the contact angles measured for nanostructured coatings prepared using a surfactant and a protic solvent are higher then the contact angle which can be measured for a strongly adherent poly(HDFDA) coating prepared using a 2 M HDFDA DMF based solution on the same surfaces (average contact angle 118° ± 4°). Moreover, nanostructured coatings, which may be called superhydrophobic because they exhibit a contact angle of more then 130°, may be obtained for all the different electrically conductive or semiconductive surfaces, due to the roughness of the strongly adherent polymer coating (Figure 2). Although the roughness seems to be correlated to the diameter of the droplets which are formed in the emulsion, the formation of hydrogen bubbles at the working electrode during the formation of the strongly adherent polymer coating, may induce an additional porosity of the polymer coating because hydrogen bubbles may be trapped in the strongly adherent polymer coatings, so that this porosity may also contribute to increase the overall roughness of the obtained strongly adherent polymer coatings.

Furthermore, the roughness depends on how the selected potential(s) is/are applied to the electrically conductive or semiconductive surfaces. When using chronoamperometry, i.e. applying a constant potential with time, rather than cyclic voltammetry, the coatings are more hydrophobic because the number of strongly adherent protuberances which are formed and subsequently the roughness of the strongly adherent polymer coating is higher. AFM measurements have confirmed that roughness of the nanostructured coating is increased when the coating is prepared by chronoamperometry whatever the used surface (carbon, steel or stainless steel). This explains the increase of the contact angle of water for these nanostructured surfaces prepared by chronoamperometry.

### Preparation of nanostructured coatings comprising poly(tert-butyl methacrylate) or poly(isooctyl acrylate) using a protic solvent

After addition of tert-butyl methacrylate (tBMA) or isooctyl acrylate (iOA) to water, an emulsion is formed upon sonication. The diameter of the droplets of tBMA and iOA of the emulsion may be measured by DLS. The diameter of the droplets is about 1 µm to 3 µm for tBMA and about 0.8 to 2 µm for iOA. The emulsion prepared using 1.5ml of tBMA is not stable and 600 µl of decaline (decahydronaphtalene) have been added to the emulsion to decrease the diameter of the tBMA droplets and to increase the stability of the emulsion.

The formation of the strongly adherent polymer coating is performed in a electrochemical cell containing 5 ml of a 1.5 M tBMA or iOA solution comprising 15 mg of cetyltrimethylammonium bromide in water at about -2.2 V for both monomers on carbon and stainless steel. The cationic surfactant also increases the conductivity of the aqueous solution. After each application of a selected potential the electrically conductive surface is washed with water and good solvents for the polymer (toluene or THF).

The nanostructured coatings prepared using tBMA or iOA, a surfactant and water are smoother as compared to coatings obtained with HDFDA. However, the presence of the strongly adherent polymer coating was assessed by ATR-FTIR. Absorptions characteristic of the polymer are observed at 1727 cm⁻¹ (C=O stretching vibration) and 1157 cm⁻¹ (C-O stretching vibration).

### Preparation of strongly adherent nanostructured coatings of ZONYL TM fluoromonomer using a protic solvent

After addition of ZONYL TM fluoromonomer (2-(perfluoroalkyl)ethyl methacrylate) to the surfactant/water mixture, an emulsion is formed upon sonication. The size of the droplets measured by DLS is about 0.5 µm to 2 µm.

The formation of the strongly adherent polymer coating is performed in a electrochemical cell containing 5 ml of 0.05 M to 1 M ZONYL TM fluoromonomer (average Mn ~ 534) solutions comprising 15 mg of cetyltrimethylammonium bromide in water at potentials between -0.8 V and -2 V depending on the concentration on stainless steel. After each application of a selected potential the electrically conductive or semiconductive surface is washed with water and trifluorotoluene.

The presence of the strongly adherent polymer coating was assessed by ATR-FTIR. Absorptions characteristic of the polymer are observed at 1727 cm⁻¹ (C=O stretching vibration) and 1157 cm⁻¹ (C-O stretching vibration). Comparable contact angle as with poly(HDFDA) were reached on these surfaces.

### Example 2: Preparation of nanostructured surfaces from monomer droplets consisting of micelles of a reactive surfactant in a selective solvent.

The monomer dimethyldecylaminoethylacrylate quaternary ammonium bromide (DMDAEABr) (scheme 4 structure A with n = 10) has been synthesized by quaternization of dimethylamino-ethylacrylate (DMAEA) with decylbromide following a general synthesis pathway described in Polymer Preprints, 2003, 44(2), 264-265 and references therein.

The formation of the nanostructured and strongly adherent polymer coating is performed in an electrochemical cell containing 5 ml of a 0.1 M of DMDAEABr solution in water at about -2.2 V on carbon. The ionic reactive surfactant ensures the conductivity of the aqueous solution. Voltammetry (Fig. 3) shows four successive scans of the potential on the same carbon electrode and clearly evidence the at least partial passivation of the surface due to the formation of the strongly adherent polymer coating. In such coating, quaternary ammonium salt is part of the nanostructured coating so that the contact angle decreases drastically below 40°. Nanostructuration of the coating is still present due to the micellar monomer droplets spontaneously formed when the monomer is put in water. Interestingly, it must be noted that surfaces coated with quaternary ammonium of this type have efficiency in bacterial lyses. In a one step and in an aqueous micellar medium, such coatings have thus been achieved.

## Claims

1. An electrogafting method for forming and regulating a strongly adherent nanostructured polymer coating onto an electro-conductive surface profile **characterized in that** the surface profile is regulated by electrodeposition of nanometre- andior micrometre-scale nuclei onto the surface profile prior to or simultaneously to the formation of the polymer coating, and **characterised in that** the nuclei are made of an organic material provided by electrodeposition from a monomer droplet or from a monomer droplet which is provided by an emulsion comprising the monomer in a protic solvent.

2. The electrografting method according to claim 1 wherein the electro-conductive surface is made of conductive and semi-conductive material.

3. The electrogafting method according to claim 1 **characterised in that** the nuclei further comprise a polymer provided by polymerisation of the monomer droplet at the conductive surface upon application of a potential z.

4. The electrografting method according to anyone of claim 1 to 3 **characterised in that** the emulsion further comprises a surfactant.

5. The electrografting method according to anyone of claim 1 to 4 **characterised in that** the protic solvent is water.

6. The electrografting method according to claim 3 **characterised in that** the potential z is applied repeatedly with different values.

7. The electrografting method according to any one of claims 1 to 6 comprising a nucleation step at the electroconductive surface inducing nanostructuration of the coating.

8. The nanostructured polymer coating obtained by the electrografting method according to any one of claims 1 to 7.

9. Use of the nanostructured polymer coating according to claim 8 for a medical device application.

10. Use of the nanostructured polymer coating according to claim 8 for a biosensor application.

11. Use of the nanostructured polymer coating according to claim 8 for a microfluidic application.

## Patentansprüche

1. Elektropfropfverfahren zur Bildung und Regulierung einer stark haftenden nanostrukturierten Polymerbeschichtung auf einem elektrisch leitfähigen Oberflächenprofil, **dadurch gekennzeichnet, dass** man das Oberflächenprofil durch Elektroabscheidung von nanometer- und/oder mikrometerskaligen Nuklei auf dem Oberflächenprofil vor oder gleichzeitig mit der Bildung der Polymerbeschichtung reguliert, und **dadurch gekennzeichnet, dass** die Nuklei aus einem durch Elektroabscheidung aus einem Monomertröpfchen oder einem durch eine Emulsion, die das Monomer in einem protischen Lösungsmittel umfasst, bereitgestellten Monomertröpfchen bereitgestellten organischen Material bestehen.

2. Elektropfropfverfahren nach Anspruch 1, bei dem die elektrisch leitfähige Oberfläche aus leitfähigem und halbleitfähigem Material besteht.

3. Elektropfropfverfahren nach Anspruch 1, **dadurch gekennzeichnet, dass** die Nuklei ferner ein durch Polymerisation des Monomertröpfchens an der leitfähigen Oberfläche beim Anlegen eines Potentials z bereitgestelltes Polymer umfassen.

4. Elektropfropfverfahren nach einem der Ansprüche 1 bis 3, **dadurch gekennzeichnet, dass** die Emulsion ferner ein Tensid umfasst.

5. Elektropfropfverfahren nach einem der Ansprüche 1 bis 4, **dadurch gekennzeichnet, dass** es sich bei dem protischen Lösungsmittel um Wasser handelt.

6. Elektropfropfverfahren nach Anspruch 3, **dadurch gekennzeichnet, dass** man das Potential z wiederholt mit verschiedenen Werten anlegt.

7. Elektropfropfverfahren nach einem der Ansprüche 1 bis 6, umfassend einen Nukleierungsschritt an der elektrisch leitfähigen Oberfläche, der eine Nanostrukturierung der Beschichtung induziert.

8. Nanostrukturierte Polymerbeschichtung, erhalten durch das Elektropfropfverfahren nach einem der Ansprüche 1 bis 7.

9. Verwendung der nanostrukturierten Polymerbeschichtung nach Anspruch 8 für eine Anwendung auf dem Gebiet medizinischer Vorrichtungen.

10. Verwendung der nanostrukturierten Polymerbeschichtung nach Anspruch 8 für eine Biosensor-Anwendung.

11. Verwendung der nanostrukturierten Polymerbeschichtung nach Anspruch 8 für eine Mikrofluidik-Anwendung.

## Revendications

1. Procédé d'électrogreffage pour former et réguler un revêtement de polymère nanostructuré à forte adhérence sur un profil de surface électroconducteur, **caractérisé en ce que** le profil de surface est régulé par dépôt électrolytique de germes à l'échelle nanométrique et/ou micrométrique sur le profil de surface avant ou simultanément à la formation du revêtement de polymère, et **caractérisé en ce que** les germes sont constitués d'un matériau organique appliqué par dépôt électrolytique depuis une gouttelette de monomère ou depuis une gouttelette de monomère qui est fournie par une émulsion comprenant le monomère dans un solvant protique.

2. Procédé d'électrogreffage selon la revendication 1 dans lequel la surface électroconductrice est constituée d'un matériau conducteur et semi-conducteur.

3. Procédé d'électrogreffage selon la revendication 1 **caractérisé en ce que** les germes comprennent en outre un polymère obtenu par polymérisation de la gouttelette de monomère au niveau de la surface conductrice lors de l'application d'un potentiel z.

4. Procédé d'électrogreffage selon l'une quelconque des revendications 1 à 3 **caractérisé en ce que** l'émulsion comprend en outre un tensioactif.

5. Procédé d'électrogreffage selon l'une quelconque des revendications 1 à 4 **caractérisé en ce que** le solvant protique est l'eau.

6. Procédé d'électrogreffage selon la revendication 3 **caractérisé en ce que** le potentiel z est appliqué de façon répétée avec des valeurs différentes.

7. Procédé d'électrogreffage selon l'une quelconque des revendications 1 à 6 comprenant une étape de nucléation au niveau de la surface électroconductrice induisant la nanostructuration du revêtement.

8. Revêtement de polymère nanostructuré obtenu par le procédé d'électrogreffage selon l'une quelconque des revendications 1 à 7.

9. Utilisation du revêtement de polymère nanostructuré selon la revendication 8 pour une application de dispositif médical.

10. Utilisation du revêtement de polymère nanostructuré selon la revendication 8 pour une application de biocapteur.

11. Utilisation du revêtement de polymère nanostructuré selon la revendication 8 pour une application microfluidique.
